# EUROPEAN PATENT APPLICATION

(11) **EP 4 535 553 A1**
(43) Date of publication of application: **09.04.2025**
(21) Application number: 23816063.4
(22) Date of filing: 30.05.2023
(51) Int. Cl.: H01P 1/26, H01L 23/02, H01S 5/022

(54) **TERMINATION CIRCUIT SUBSTRATE, PACKAGE FOR MOUNTING ELECTRONIC COMPONENT, AND ELECTRONIC MODULE**

(30) Priority: 01.06.2022 JP 2022089677
(71) Applicant: Kyocera Corporation, Kyoto-shi, Kyoto 612-8501 (JP)
(72) Inventor: KAWAZU Yoshiki, Kyoto-shi, Kyoto 612-8501 (JP)
(74) Representative: Viering, Jentschura & Partner mbB Patent- und Rechtsanwälte
(86) International application number: PCT/JP2023/020127
(87) International publication number: WO 2023/234306

(57) **Abstract**

A termination circuit board includes a dielectric substrate, a ground conductor part, a signal conductor part, a first resistor part, and a second resistor part. The ground conductor part includes a first ground conductor line, a second ground conductor line, a third ground conductor line, and a fourth ground conductor line aligned in order. The signal conductor part includes a first signal line positioned between the first ground conductor line and the second ground conductor line, and a second signal line positioned between the third ground conductor line and the fourth ground conductor line. The first resistor part includes a first resistor that couples the first ground conductor line to the first signal line, a second resistor that couples the second ground conductor line to the first signal line, a third resistor that couples the third ground conductor line to the second signal line, and a fourth resistor that couples the fourth ground conductor line to the second signal line. The second resistor part couples the second ground conductor line to the third ground conductor line.

## Description

### TECHNICAL FIELD

The present disclosure relates to a termination circuit board, an electronic component mounting package, and an electronic module.

### BACKGROUND OF INVENTION

In a known art, a semiconductor element accommodating package that accommodates a semiconductor element utilizes a wiring board that is coupled to the semiconductor element. The semiconductor element processes an electrical signal (for example, a radio-frequency signal). A known example of the wiring board is a wiring board described in Patent Literature 1. The wiring board described in Patent Literature 1 includes a resistor to convert a signal including a radio-frequency signal component from electrical energy to thermal energy to reduce noise due to reflection of the signal.

Specifically, the wiring board described in Patent Literature 1 includes a signal line conductor on a dielectric substrate, a first ground conductor disposed on both sides of the signal line conductor with a gap between the first ground conductor and the signal line, and a resistor coupling one end of the signal line conductor and the first ground conductor.

### CITATION LIST

### PATENT LITERATURE

Patent Literature 1: Japanese Unexamined Patent Application Publication No. 2010-135712

### SUMMARY

In an embodiment of the present disclosure, (1) a termination circuit board includes a dielectric substrate, a ground conductor part, a signal conductor part, a first resistor part, and a second resistor part. The dielectric substrate includes a first surface with a first side. When a direction along the first side is a first direction and a direction intersecting with the first direction is a second direction, the ground conductor part is positioned on the first surface in such a manner that a distance in the second direction between the ground conductor part and the first side is a first distance. The signal conductor part is positioned on the first surface in such a manner that a distance in the second direction between the signal conductor part and the first side is a second distance. The first resistor part is positioned on the first surface and coupling the ground conductor part to the signal conductor part. The second resistor part is positioned on the first surface in such a manner that a distance in the second direction between the second resistor part and the first side is a third distance. The ground conductor part includes a first ground conductor line, a second ground conductor line, a third ground conductor line, and a fourth ground conductor line aligned in order in the first direction. The signal conductor part includes a first signal line positioned between the first ground conductor line and the second ground conductor line in the first direction, and a second signal line positioned between the third ground conductor line and the fourth ground conductor line in the first direction. The first resistor part includes a first resistor that couples the first ground conductor line to the first signal line in the first direction, a second resistor that couples the second ground conductor line to the first signal line in the first direction, a third resistor that couples the third ground conductor line to the second signal line in the first direction, and a fourth resistor that couples the fourth ground conductor line to the second signal line in the first direction. The second resistor part couples the second ground conductor line to the third ground conductor line in the first direction.
(2) A termination circuit board includes a dielectric substrate, a ground conductor part, a signal conductor part, and a first resistor part. The dielectric substrate includes a first surface with a first side. When a direction along the first side is a first direction and a direction intersecting with the first direction is a second direction, the ground conductor part is positioned on the first surface in such a manner that a distance in the second direction between the ground conductor part and the first side is a first distance. The signal conductor part is positioned on the first surface in such a manner that a distance in the second direction between the signal conductor part and the first side is a second distance. The first resistor part is positioned on the first surface and coupling the ground conductor part to the signal conductor part. The ground conductor part includes a first ground conductor line, a second ground conductor line, a third ground conductor line, and a fourth ground conductor line aligned in order in the first direction. The signal conductor part includes a first signal line positioned between the first ground conductor line and the second ground conductor line in the first direction, and a second signal line positioned between the third ground conductor line and the fourth ground conductor line in the first direction. The first resistor part includes a first resistor that couples the first ground conductor line to the first signal line in the first direction, a second resistor that couples the second ground conductor line to the first signal line in the first direction, a third resistor that couples the third ground conductor line to the second signal line in the first direction, and a fourth resistor that couples the fourth ground conductor line to the second signal line in the first direction. The second ground conductor line and the third ground conductor line are positioned apart from one another in the first direction.
(3) In the termination circuit board of (1) or (2) described above, the first surface includes a first region and a second region. The first region is positioned with a gap between the first region and the first side and extends in the first direction. The second region is positioned between the first side and the first region and extends in the first direction. The first signal line, the second signal line, the first ground conductor line, the second ground conductor line, the third ground conductor line, and the fourth ground conductor line extend from the second region to the first region in the second direction intersecting with the first direction. The first resistor, the second resistor, the third resistor, and the fourth resistor are positioned only in the first region. In the first direction, a distance in the second region between the first signal line and each of the first ground conductor line and the second ground conductor line is shorter than a distance in the first region between the first signal line and each of the first ground conductor line and the second ground conductor line.
(4) In the termination circuit board of (1) to (3) described above, in the second direction intersecting with the first direction, a dimension of each of the first signal line and the second signal line is equal to or more than a dimension of each of the first ground conductor line, the second ground conductor line, the third ground conductor line, and the fourth ground conductor line.
(5) In the termination circuit board of (1), (3), (4) described above, the first surface includes a first region and a second region. The first region is positioned with a gap between the first region and the first side and extends in the first direction. The second region is positioned between the first side and the first region and extends in the first direction. In the second region, the first ground conductor line includes a first end part, the second ground conductor line includes a second end part, the third ground conductor line includes a third end part, the fourth ground conductor line includes a fourth end part, the first signal line includes a fifth end part, the second signal line includes a sixth end part, and the second resistor part includes a seventh end part. The first end part, the second end part, the third end part, the fourth end part, the fifth end part, the sixth end part, and the seventh end part are positioned in a straight line in the first direction.
(6) In the termination circuit board of (2) to (4) described above, the first surface includes a first region and a second region. The first region is positioned with a gap between the first region and the first side and extends in the first direction. The second region is positioned between the first side and the first region and extends in the first direction. In the second region, the first ground conductor line includes a first end part, the second ground conductor line includes a second end part, the third ground conductor line includes a third end part, the fourth ground conductor line includes a fourth end part, the first signal line includes a fifth end part, and the second signal line includes a sixth end part. The first end part, the second end part, the third end part, the fourth end part, the fifth end part, and the sixth end part are positioned in a straight line in the first direction.
(7) The termination circuit board of (1) to (6) described above further includes a third resistor part and a fourth resistor part positioned on the first surface. The ground conductor part further includes a fifth ground conductor line and a sixth ground conductor line. The third resistor part couples the first ground conductor line to the fifth ground conductor line. The fourth resistor part couples the fourth ground conductor line to the sixth ground conductor line.
(8) The termination circuit board of (1) to (7) described above further includes a fifth resistor part positioned with a gap between the fifth resistor part and each of the first signal line and the second signal line. The ground conductor part includes a seventh ground conductor line positioned with a gap between the seventh ground conductor line and a first region and extending in the first direction. The first surface includes the first region and a second region. The first region is positioned with a gap between the first region and the first side and extends in the first direction. The second region is positioned between the first side and the first region and extends in the first direction. The fifth resistor part is coupled to the first ground conductor line, the second ground conductor line, the third ground conductor line, and the fourth ground conductor line, as well as to the seventh ground conductor line.
(9) The termination circuit board of (1) to (8) described above further includes a fifth resistor part positioned with a gap between the fifth resistor part and each of the first signal line and the second signal line. The ground conductor part includes a seventh ground conductor line positioned with a gap between the seventh ground conductor line and a first region and extending in the first direction, and an eighth ground conductor line positioned between the seventh ground conductor line and the first region and extending in the first direction. The eighth ground conductor line is coupled to the first ground conductor line, the second ground conductor line, the third ground conductor line, and the fourth ground conductor line. The fifth resistor part is coupled to the seventh ground conductor line and the eighth ground conductor line.
(10) The termination circuit board of (1) to (9) described above further includes a first wire, a second wire, a third wire, and a fourth wire. The first wire and the second wire electrically couple the first signal line to an electronic component. The third wire and the fourth wire electrically couple the second signal line to the electronic component. In plan view, a distance in the first direction between the first wire and the second wire decreases outwardly in the second direction, and a distance in the first direction between the third wire and the fourth wire decreases outwardly in the second direction.
(11) In the termination circuit board of (1) to (10) described above, each of the first resistor part and the second resistor part is a thin-film resistor.
(12) In the termination circuit board of (1) to (11) described above, a material for the first resistor part and the second resistor part contains TaN or Ta2N as a main component.
(13) In the termination circuit board of (1) to (12) described above, the first signal line includes a third signal line, and a fourth signal line positioned with a gap between the fourth signal line and the third signal line. The second signal line includes a fifth signal line, and a sixth signal line positioned with a gap between the sixth signal line and the fifth signal line. The first resistor part further includes a fifth resistor, a sixth resistor, a seventh resistor, and an eighth resistor. In side view in the second direction, the fifth resistor overlaps the third signal line, the sixth resistor overlaps the fourth signal line, the seventh resistor overlaps the fifth signal line, and the eighth resistor overlaps the sixth signal line. The first resistor and the fifth resistor couple the third signal line to the first ground conductor line. The second resistor and the sixth resistor couple the fourth signal line to the second ground conductor line. The third resistor and the seventh resistor couple the fifth signal line to the third ground conductor line. The fourth resistor and the eighth resistor couple the sixth signal line to the fourth ground conductor line.
(14) According to an embodiment of the present disclosure, an electronic component mounting package includes a base part, a frame body, and the termination circuit board described above in (1) to (13). The frame body is bonded to an upper surface of the base part. The termination circuit board is mounted on the upper surface.
(15) According to an embodiment of the present disclosure, an electronic module includes the electronic component mounting package described above in (14), an electronic component, and a lid body. The electronic component is positioned on the upper surface of the base part and electrically coupled to the termination circuit board of the electronic component mounting package. The lid body is positioned on the frame body to cover an internal portion of the electronic component mounting package.

### BRIEF DESCRIPTION OF THE DRAWINGS

FIG. 1 is a plan view of a termination circuit board according to a first embodiment of the present disclosure.
FIG. 2 is a plan view of a variation of the termination circuit board according to the first embodiment of the present disclosure.
FIG. 3 is a plan view of a termination circuit board according to a second embodiment of the present disclosure.
FIG. 4 is a plan view of a termination circuit board according to a third embodiment of the present disclosure.
FIG. 5 is a plan view of a variation of the termination circuit board according to the third embodiment of the present disclosure.
FIG. 6 is a plan view of a termination circuit board according to a fourth embodiment of the present disclosure.
FIG. 7 is a perspective view of the termination circuit board according to the first embodiment of the present disclosure.
FIG. 8 is an enlarged plan view of a part A of interest illustrate in FIG. 7.
FIG. 9 is a certain sectional view of the termination circuit board, an electronic component mounting package, and an electronic module according to the first embodiment of the present disclosure.

### DESCRIPTION OF EMBODIMENTS

### <Configuration of Termination Circuit Board>

Hereinafter, several exemplary embodiments of the present disclosure are described with reference to the drawings. Note that any direction may be defined as an upper direction or a lower direction regarding a termination circuit board. However, for convenience, an orthogonal coordinate system xyz is defined, and a positive side in a z-direction is assumed as the upper direction. Below, a first direction indicates, for example, an x-direction in the drawings. A second direction intersecting with the first direction indicates, for example, a y-direction in the drawings. In the present disclosure, plan view is a concept including planar transparent view.

### (First Embodiment)

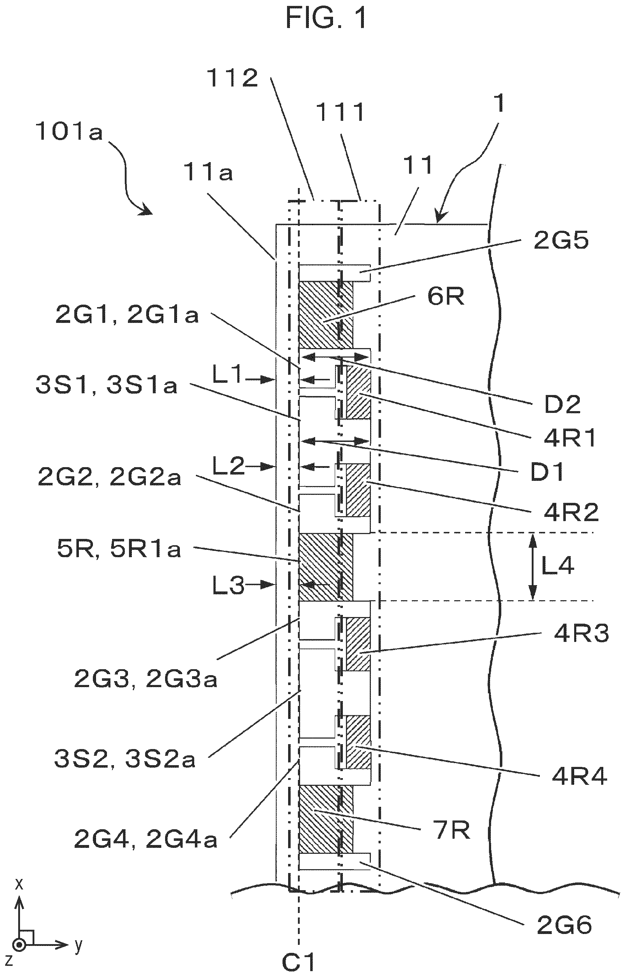

In a first embodiment of the present disclosure, termination circuit boards 101a to 101d are described with reference to FIGs. 1, 2, 7, and 8. As illustrated in FIG. 1, the termination circuit board 101a at least includes a dielectric substrate 1, a ground conductor part 2G, a signal conductor part 3S, a first resistor part 4R, and a second resistor part 5R.

The dielectric substrate 1 includes a first surface 11 with a first side 11a. As a material for the dielectric substrate 1, for example, a dielectric material, such as a ceramic material, for example, an aluminum oxide-based sintered body, a mullite-based sintered body, a silicon carbide-based sintered body, an aluminum nitride-based sintered body, or a silicon nitride-based sintered body, or a glass-ceramic material can be used.

The dielectric substrate 1 may include a configuration in which multiple dielectrics are laminated on one another. For example, the dielectric substrate 1 has a rectangular shape in plan view, a size of 4 mm × 4 mm to 50 mm × 50 mm, and a thickness of 0.5 mm to 10 mm.

Assuming that a direction along the first side 11a is the first direction (in an embodiment, the x-direction), and a direction intersecting with the first direction is the second direction (in an embodiment, the y-direction), as illustrated in FIG. 1, the ground conductor part 2G is positioned on the first surface 11, and a distance in the second direction between the ground conductor part 2G and the first side 11a is a first distance L1. Note that in an embodiment, as illustrated in FIG. 1, the first side 11a and the ground conductor part 2G are positioned apart from one another. However, the first side 11a and the ground conductor part 2G are not necessarily positioned apart from one another. That is, a value of the first distance L1 may be zero. The same and/or similar also applies to a second distance L2 and a third distance L3 which will be described later. When the first side 11a and the ground conductor part 2G are positioned apart from one another, the ground conductor part 2G, the signal conductor part 3S, the first resistor part 4R, and the second resistor part 5R can have less possibility of getting damaged when the dielectric substrate 1 to be the termination circuit board 101a is manufactured by dicing.

The ground conductor part 2G includes a first ground conductor line 2G1, a second ground conductor line 2G2, a third ground conductor line 2G3, and a fourth ground conductor line 2G4 aligned in order in the x-direction. More specifically, as illustrated in FIG. 1, the first ground conductor line 2G1, the second ground conductor line 2G2, the third ground conductor line 2G3, and the fourth ground conductor line 2G4 are aligned in order from the positive side in the x-direction. The first ground conductor line 2G1 and the second ground conductor line 2G2 extend in the y-direction and are positioned with a gap therebetween. In the same and/or similar manner, the third ground conductor line 2G3 and the fourth ground conductor line 2G4 extend in the y-direction and are positioned with a gap therebetween. The second ground conductor line 2G2 and the third ground conductor line 2G3 extend in the y-direction and are positioned with a gap (fourth distance L4) therebetween.

Examples of a material for the ground conductor part 2G (the first ground conductor line 2G1, the second ground conductor line 2G2, the third ground conductor line 2G3, and the fourth ground conductor line 2G4) include a metal material, such as gold, silver, copper, nickel, tungsten, molybdenum, or manganese. The ground conductor part 2G may be formed by sintering of metal paste on the first surface 11, or formed by using a thin-film formation technology, such as a vapor deposition method or a spattering method. An insulating film, such as a ceramic (for example, aluminum coat) or a resin may be positioned on a portion of the ground conductor part 2G. The insulating film can be provided onto the ground conductor part 2G by screen printing. The insulating film may be positioned only on a portion of each signal line. Such a configuration can lower possibility of short-circuiting in each signal line.

As described above, in an embodiment, the first ground conductor line 2G1, the second ground conductor line 2G2, the third ground conductor line 2G3, and the fourth ground conductor line 2G4 are positioned to separate from one another. Therefore, crosstalk characteristics in the signal conductor part 3S can have less possibility of deteriorating due to wrapping-around of a radio-frequency signal from the ground conductor part 2G. Note that the first ground conductor line 2G1, the second ground conductor line 2G2, the third ground conductor line 2G3, and the fourth ground conductor line 2G4 are not necessarily positioned to separate from one another, but as will be described later in a fourth embodiment, they may be coupled to one another via an eighth ground conductor line 2G8.

The signal conductor part 3S is positioned on the first surface 11, and a distance between the signal conductor part 3S and the first side 11a in the y-direction is the second distance L2. The signal conductor part 3S includes a first signal line 3S1 positioned between the first ground conductor line 2G1 and the second ground conductor line 2G2 in the x-direction, and a second signal line 3S2 positioned between the third ground conductor line 2G3 and the fourth ground conductor line 2G4 in the x-direction.

A material for the signal conductor part 3S (the first signal line 3S1, the second signal line 3S2) may be the same as or different from the material for the ground conductor part 2G, and be, for example, a material the same as and/or similar to the material for the ground conductor part 2G described above. The signal conductor part 3S may be formed in a method the same as and/or similar to that for the ground conductor part 2G. Positioning of the first signal line 3S1 between the first ground conductor line 2G1 and the second ground conductor line 2G2 can reinforce ground potential and strengthen electric-field coupling. Therefore, the first signal line 3S1 can have less possibility of occurrence of resonance that occurs due to spreading of electric field distribution beyond an intended range during transmission of a radio-frequency signal. Positioning of the second signal line 3S2 between the third ground conductor line 2G3 and the fourth ground conductor line 2G4 can achieve an effect as that of the case described above.

The first signal line 3S1 and the second signal line 3S2 may be a pair of differential signal lines that transmit differential signals. In such a case, current in opposite directions flow through the pair of signal lines to cancel out external noise. Therefore, influence of EMI noise can decrease and transmission of a radio-frequency signal can be smoother.

The first resistor part 4R is positioned on the first surface 11 and couples the ground conductor part 2G to the signal conductor part 3S. The first resistor part 4R includes a first resistor 4R1, a second resistor 4R2, a third resistor 4R3, and a fourth resistor 4R4. The first resistor 4R1 couples the first ground conductor line 2G1 to the first signal line 3S1 in the x-direction. The second resistor 4R2 couples the second ground conductor line 2G2 to the first signal line 3S1. The third resistor 4R3 couples the third ground conductor line 2G3 to the second signal line 3S2. The fourth resistor 4R4 couples the fourth ground conductor line 2G4 to the second signal line 3S2.

Note that "couple" as mentioned above means coupling in a physical way. For example, "the first resistor part 4R couples the ground conductor part 2G to the signal conductor part 3S" includes a case in which the first resistor part 4R is in contact with the ground conductor 2G and the signal conductor part 3S, and also a case in which a part of the first resistor part 4R is positioned in such a manner as to overlap the ground conductor 2G and the signal conductor part 3S.

The first resistor part 4R (the first resistor 4R1, the second resistor 4R2, the third resistor 4R3, and the fourth resistor 4R4) is made of a material with higher resistivity than that of the signal conductor part 3S. Examples of the material for the first resistor part 4R include a resistor material, such as tantalum nitride (TaN or Ta2N), ruthenium oxide (RuO2), nickel-chrome alloy (Ni-Cr), copper-nickel alloy (Cu-Ni), or copper-manganese alloy (Cu-Mn). For example, when the resistor material is composed of Ta2N, the first resistor part 4R may be formed on the dielectric substrate 1 (in an embodiment, on the first surface 11) by using a thin-film formation technology. Alternatively, the first resistor part 4R may be formed in a thick-film method in which paste containing a powdered resistor material as a main component is printed and applied on the dielectric substrate 1 and sintered.

The second resistor part 5R is positioned on the first surface 11, and a distance between the second resistor part 5R and the first side 11a in the y-direction is the third distance L3. The second resistor part 5R couples the second ground conductor line 2G2 to the third ground conductor line 2G3 in the x-direction. A material for the second resistor part 5R may be the same as or different from the material for the first resistor part 4R, and be, for example, a material the same as and/or similar to the material for the first resistor part 4R described above. The second resistor part 5R may be formed on the dielectric substrate 1 in a method the same as and/or similar to that for the first resistor part 4R.

As described above, in the first embodiment, the termination circuit board 101a includes the second resistor part 5R coupling the second ground conductor line 2G2 to the third ground conductor line 2G3. Therefore, an unnecessary electrical signal generated between the first signal line 3S1 and the second signal line 3S2 is convertible to thermal energy. Accordingly, an unnecessary electrical signal can have less possibility of reflecting toward the first signal line 3S1 and the second signal line 3S2. Thereby, transmission characteristics improve even in the case of transmission of a radio-frequency signal, and the termination circuit board 101a capable of obtaining favorable reflection characteristics is achievable.

In an embodiment, each of the first resistor part 4R and the second resistor part 5R is a thin-film resistor. Since the first resistor part 4R and the second resistor part 5R are thin-film resistors, the termination circuit board 101a can have a reduced size and a reduced height. Note that when the first resistor part 4R and the second resistor part 5R are thin-film resistors, the first resistor part 4R and the second resistor part 5R can be formed on the dielectric substrate 1 (in an embodiment, on the first surface 11) by using a thin-film formation technology described above. Here, the thin-film resistor indicates a resistor with a thickness of 100 um or less, for example. When the first resistor part 4R and the second resistor part 5R are made of thin films, the first resistor part 4R and the second resistor part 5R are excellent in precision of dimension, and thus can have improved precision of a resistance value. As compared with a case in which the first resistor part 4R and the second resistor part 5R are chip resistors, mounting of the chip resistors is unnecessary, and thereby the termination circuit board 101a can have a reduced number of components and reduced possibility of deterioration in reflection characteristics due to the chip resistor mounting part.

In an embodiment, tantalum nitride (TaN or Ta2N) is used as a main component of the first resistor part 4R and second resistor part 5R. Note that the first resistor part 4R and the second resistor part 5R are not each limited to that consisting of a conductor layer as described above, but may be an independent part (a so-called chip resistor or the like), or may be formed by combination of these multiple types. Here, "main component" in the present disclosure indicates at least a component with a highest content rate, and is, for example, a component with a content rate of 90% or more.

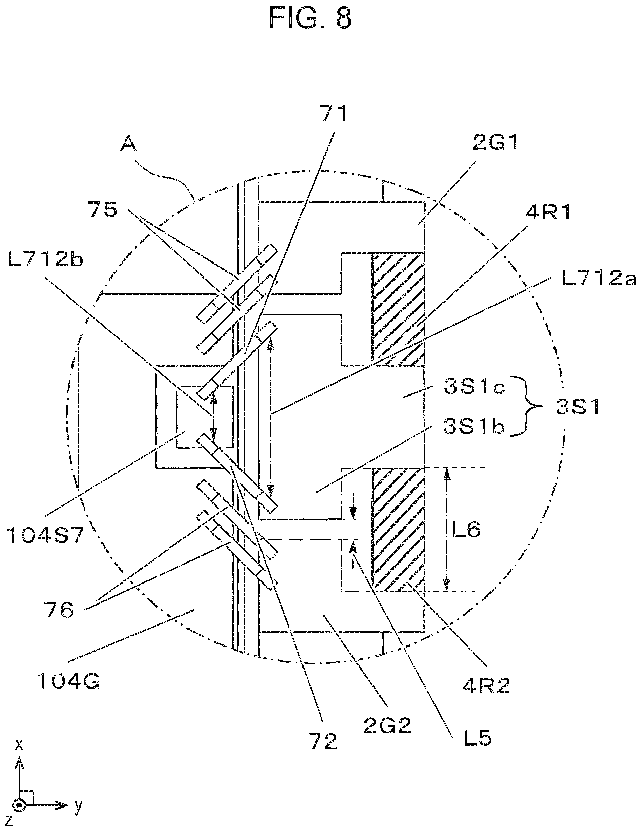

In an embodiment, as illustrated in FIGs. 1 and 8, the termination circuit board 101a may include the first surface 11 including a first region 111 and a second region 112. In this case, the first region 111 is positioned with a gap between the first region 111 and the first side 11a and extends in the x-direction. The second region 112 is positioned between the first side 11a and the first region 111 and extends in the x-direction. The first signal line 3S1, the second signal line 3S2, the first ground conductor line 2G1, the second ground conductor line 2G2, the third ground conductor line 2G3, and the fourth ground conductor line 2G4 extend from the second region 112 to the first region 111 in the y-direction intersecting with the x-direction. The first resistor 4R1, the second resistor 4R2, the third resistor 4R3, and the fourth resistor 4R4 are positioned only in the first region 111. In the x-direction, a fifth distance L5 in the second region 112 between the first signal line 3S1 and each of the first ground conductor line 2G1 and the second ground conductor line 2G2 is shorter than a sixth distance L6 in the first region 111 between the first signal line 3S1 and each of the first ground conductor line 2G1 and the second ground conductor line 2G2. The configuration as described above makes adjustment of impedance to be an intended value easier at the first signal line 3S1 and the second signal line 3S2. When a first wire 71, a second wire 72, and/or the like, which will be described later, are connected to the first signal line 3S1 in the second region 112, since the first signal line 3S1 is positioned to be close to the first ground conductor line 2G1 and the second ground conductor line 2G2, a capacity component can increase. Thereby, impedance matching of the first signal line 3S1 can be easier. The same and/or similar applies to the second signal line 3S2. Such a termination circuit board 101a is excellent in transmission characteristics of a radio-frequency signal.

More specifically, in an embodiment, the first signal line 3S1 may include in the second region 112 a first wide part 3S1b whose dimension in the y-direction is larger than that of a portion (first narrow part 3S1c) positioned in the first region 111. In the same and/or similar manner, each of the second signal line 3S2, the first ground conductor line 2G1, the second ground conductor line 2G2, the third ground conductor line 2G3, and the fourth ground conductor line 2G4 may include a narrow part in the first region 111 and a wide part in the second region 112. That is, the respective wide parts in the second region 112 are positioned closer to one another in the y-direction as compared with the narrow parts in the first region 111. Therefore, in addition to the effect described above, a region to connect the first wire 71 and/or the like to the signal conductor part 3S and the ground conductor part 2G can be secured, and electrical coupling between an electronic component 104 described later and the termination circuit board 101a can be easier. The first wire 71 and/or the like are used for coupling with the electronic component 104.

In the y-direction intersecting with the x-direction, a first dimension D1 of each of the first signal line 3S1 and the second signal line 3S2 may be equal to or more than a second dimension D2 of each of the first ground conductor line 2G1, the second ground conductor line 2G2, the third ground conductor line 2G3, and the fourth ground conductor line 2G4. Such a configuration makes adjustment of impedance to be an intended value easier at the first signal line 3S1 and the second signal line 3S2. Such a termination circuit board 101a is excellent in transmission characteristics of a radio-frequency signal. In an embodiment, the first dimension D1 of each of the first signal line 3S1 and the second signal line 3S2 is the same as the second dimension D2 of each of the first ground conductor line 2G1, the second ground conductor line 2G2, the third ground conductor line 2G3, and the fourth ground conductor line 2G4.

In the second region 112, the first ground conductor line 2G1 includes a first end part 2G1a, the second ground conductor line 2G2 includes a second end part 2G2a, the third ground conductor line 2G3 includes a third end part 2G3a, the fourth ground conductor line 2G4 includes a fourth end part 2G4a, the first signal line 3S1 includes a fifth end part 3S1a, the second signal line 3S2 includes a sixth end part 3S2a, and the second resistor part 5R includes a seventh end part 5R1a. The first end part 2G1a, the second end part 2G2a, the third end part 2G3a, the fourth end part 2G4a, the fifth end part 3S1a, the sixth end part 3S2a, and the seventh end part 5R1a are positioned in a straight line (virtual line C1) in the x-direction. Such a configuration enables transmission characteristics of a radio-frequency signal at the first signal line 3S1 and second signal line 3S2 to be close to uniform.

More specifically, the ground conductor part 2G, the signal conductor part 3S, and the second resistor part 5R described above are positioned with a gap between the first side 11a and each of the ground conductor part 2G, the signal conductor part 3S, and the second resistor part 5R in the y-direction, and L1 = L2 = L3 are satisfied. In this case, in addition to the effect described above, the ground conductor part 2G, the signal conductor part 3S, the first resistor part 4R, and the second resistor part 5R can have less possibility of getting damaged when the dielectric substrate 1 to be the termination circuit board 101a is manufactured by dicing.

As illustrated in FIG. 1, the termination circuit board 101a may further include a third resistor part 6R and a fourth resistor part 7R positioned on the first surface 11. In this case, the ground conductor part 2G may further include a fifth ground conductor line 2G5 and a sixth ground conductor line 2G6. The third resistor part 6R couples the first ground conductor line 2G1 to the fifth ground conductor line 2G5, and the fourth resistor part 7R couples the fourth ground conductor line 2G4 to the sixth ground conductor line 2G6. With such a configuration, an unnecessary electrical signal generated between the first signal line 3S1 and the second signal line 3S2 is further efficiently convertible to thermal energy. Therefore, the termination circuit board 101a can have less possibility of occurrence of resonance and can achieve favorable reflection characteristics.

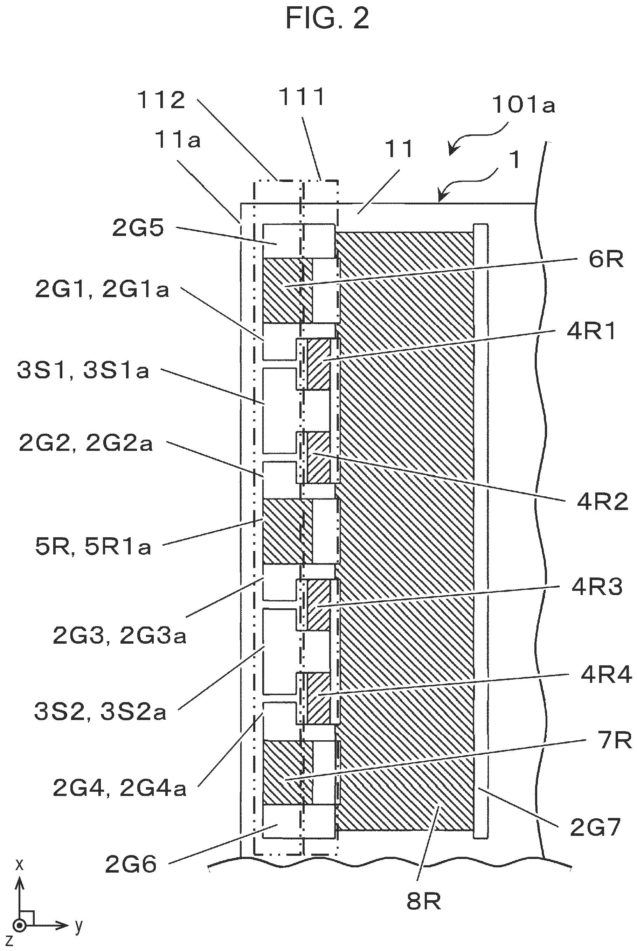

As illustrated in FIG. 2, the termination circuit board 101a may include a fifth resistor part 8R positioned with a gap between the fifth resistor part 8R and each of the first signal line 3S1 and the second signal line 3S2. The ground conductor part 2G includes a seventh ground conductor line 2G7 positioned with a gap between the seventh ground conductor line 2G7 and the first region 111 and extending in the x-direction. As described above, the first surface 11 includes the first region 111 and the second region 112. That is, the first region 111 is positioned with a gap between the first region 111 and the first side 11a and extends in the x-direction. The second region 112 is positioned between the first side 11a and the first region 111 and extends in the x-direction. The fifth resistor part 8R is coupled to the first ground conductor line 2G1, the second ground conductor line 2G2, the third ground conductor line 2G3, and fourth ground conductor line 2G4, as well as to the seventh ground conductor line 2G7. With such a configuration, as compared with the case without the fifth resistor part 8R, an unnecessary electrical signal generated between the first signal line 3S1 and the second signal line 3S2 is more efficiently convertible to thermal energy. Accordingly, an unnecessary electrical signal can have less possibility of reflecting toward the first signal line 3S1 and the second signal line 3S2.

In an embodiment, the fifth resistor part 8R is positioned to separate from the second resistor part 5R, the third resistor part 6R, and the fourth resistor part 7R. However, the fifth resistor part 8R is not necessarily positioned to separate from the second resistor part 5R, the third resistor part 6R, and the fourth resistor part 7R. That is, the fifth resistor part 8R may be coupled to each of the second resistor part 5R, the third resistor part 6R, and the fourth resistor part 7R, or may be coupled to any one of them.

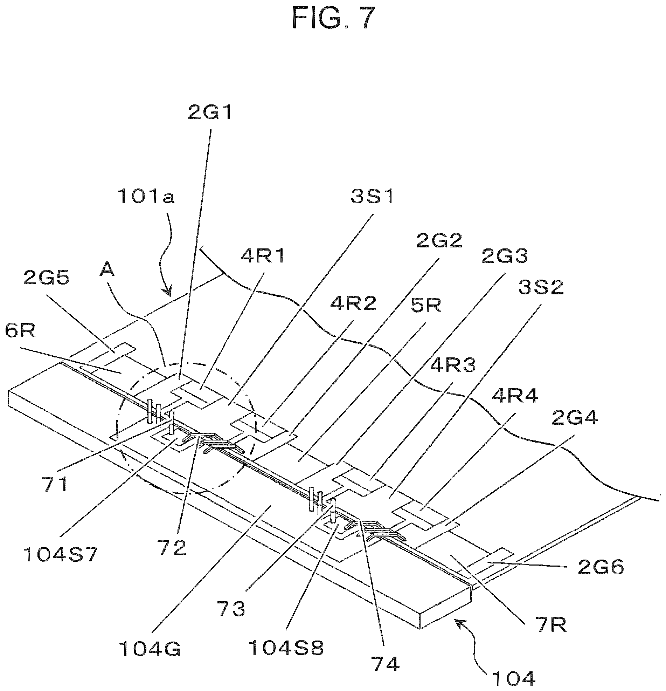

As illustrated in FIGs. 7 and 8, the termination circuit board 101a may further include the first wire 71, the second wire 72, a third wire 73, and a fourth wire 74. The first wire 71 and the second wire 72 electrically couple the first signal line 3S1 to the electronic component 104. The third wire 73 and the fourth wire 74 electrically couple the second signal line 3S2 to the electronic component 104. In plan view, a distance L712 in the x-direction between the first wire 71 and the second wire 72 decreases outwardly in the y-direction (in an embodiment, in the negative direction of the y-axis). A distance L734 in the x-direction between the third wire 73 and the fourth wire 74 decreases outwardly in the y-direction (in the negative direction of the y-axis). With such a configuration, in a signal transmission between the electronic component 104 and each of the first signal line 3S1 and the second signal line 3S2 of the termination circuit board 101a, impedance can have less possibility of drastic fluctuation, and an unnecessary electrical signal can have less possibility of reflecting toward the first signal line 3S1 and the second signal line 3S2.

More specifically, as illustrated in FIG. 8, assuming that a distance in the x-direction between the first wire 71 and the second wire 72 at a part where the first wire 71 and the second wire 72 are connected to the first signal line 3S1 is L712a, and a distance in the x-direction between the first wire 71 and the second wire 72 at a part where the first wire 71 and the second wire 72 are connected to the electronic component 104 is L712b, L712a > L712b is satisfied. Although not illustrated, assuming that a distance in the x-direction between the third wire 73 and the fourth wire 74 at a part where the third wire 73 and the fourth wire 74 are connected to the second signal line 3S2 is L734a, and a distance in the x-direction between the third wire 73 and the fourth wire 74 at a part where the third wire 73 and the fourth wire 74 are connected to the electronic component 104 is L734b, L734a > L734b is satisfied.

Note that as illustrated in FIG. 8, in an embodiment, the first wire 71 and the second wire 72 electrically couple the first signal line 3S1 to a seventh signal line 104S7 of the electronic component 104. Although not illustrated, the same as and/or similarly to the first wire 71 and the second wire 72, the third wire 73 and the fourth wire 74 electrically couple the second signal line 3S2 to an eighth signal line 104S8 of the electronic component 104.

In an embodiment, as illustrated in FIG. 8, in plan view, an absolute value of an inclination of the first wire 71 with respect to the x-direction may be the same as an absolute value of an inclination of the second wire 72 with respect to the x-direction. That is, the inclination of the first wire 71 with respect to the x-direction is symmetrical to the inclination of the second wire 72 with respect to the x-direction while sandwiching the first signal line 3S1 therebetween. In an embodiment, the third wire 73 and the fourth wire 74 also have the same and/or similar configuration as or to the configuration of the first wire 71 and the second wire 72 described above.

The termination circuit board 101a may include one or more fifth wires 75, and one or more sixth wires 76. The fifth wire 75 is positioned farther from the second wire 72 than the first wire 71 is, and couples the first ground conductor line 2G1 to a tenth ground conductor line 104G of the electronic component 104. The sixth wire 76 is positioned farther from the first wire 72 than the second wire 71 is, and couples the second ground conductor line 2G2 to the tenth ground conductor line 104G. In an embodiment, an inclination of the fifth wire 75 with respect to x-direction is the same as the inclination of the first wire 71 with respect to the x-direction. An inclination of the sixth wire 76 with respect to x-direction is the same as the inclination of the second wire 72 with respect to the x-direction. Note that a positional relationship of each of the first wire 71, the second wire 72, the third wire 73, the fourth wire 74, the fifth wire 75, and the sixth wire 76 is not limited to the embodiment described above.

Examples of a material for the first wire 71 include a conductive metal material such as platinum. A material for each of the second wire 72, the third wire 73, the fourth wire 74, the fifth wire 75, and the sixth wire 76 may be the same as or different from the material for the first wire 71.

### (Second Embodiment)

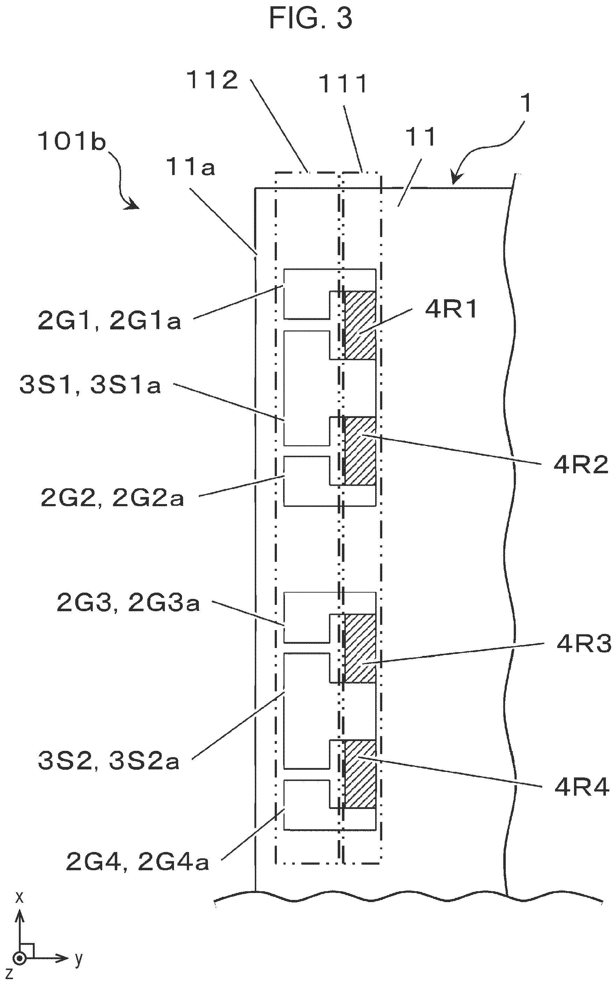

According to a second embodiment of the present disclosure, the termination circuit board 101b is described with reference to FIG. 3. Note that, below, only a configuration of the second embodiment different from the configuration of the first embodiment is described, and the other configurations are denoted by the same reference signs as those in the first embodiment to omit description.

According to the second embodiment of the present disclosure, the termination circuit board 101b is different from the first embodiment in that the second ground conductor line 2G2 and the third ground conductor line 2G3 are positioned apart from one another. Here, the second ground conductor line 2G2 and the third ground conductor line 2G3 being positioned apart from one another means the second ground conductor line 2G2 and the third ground conductor line 2G3 being positioned to separate from one another, and not being even electrically coupled to one another on the termination circuit board 101b. That is, an embodiment does not include the second resistor part 5R of the first embodiment between the second ground conductor line 2G2 and the third ground conductor line 2G3. Therefore, providing of the second resistor part 5R is unnecessary, and thus manufacturing of the termination circuit board 101b can require reduced man-hours.

### (Third Embodiment)

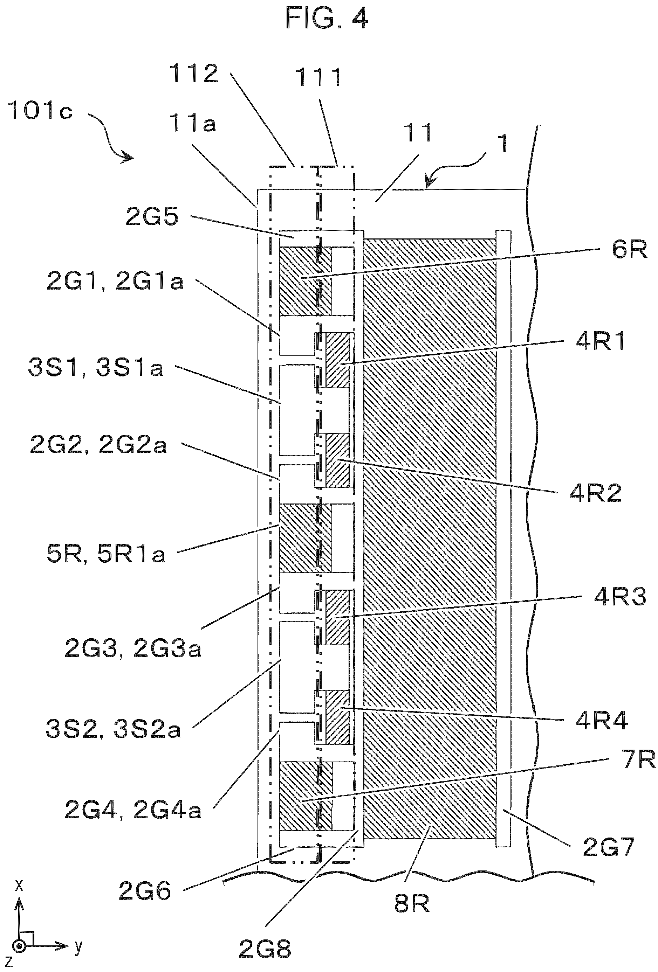

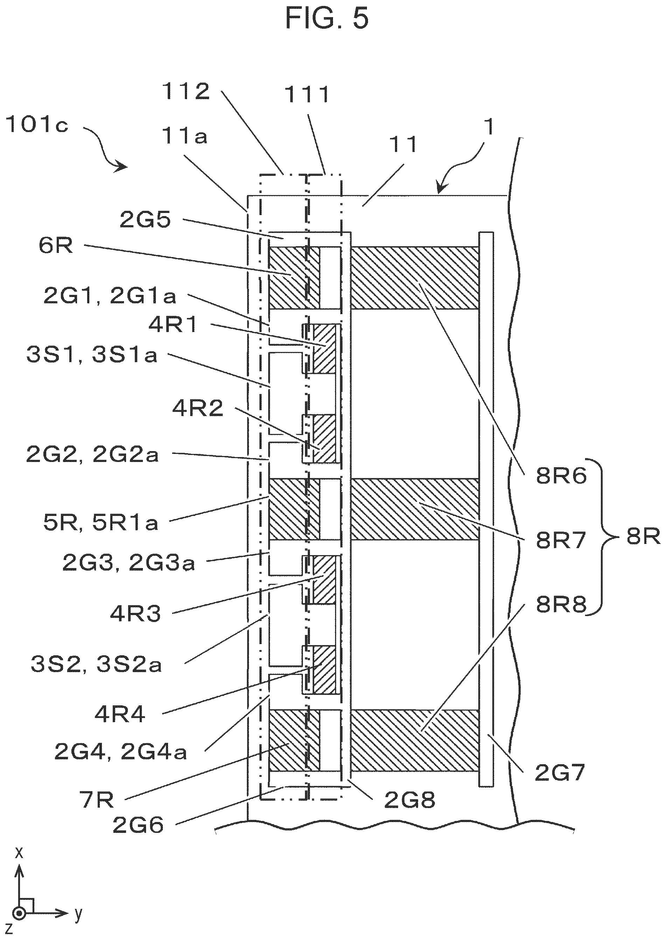

According to a third embodiment of the present disclosure, the termination circuit board 101c is described with reference to FIGs. 4 and 5. Note that, below, only a configuration of the third embodiment different from the configuration of the first embodiment is described, and the other configurations are denoted by the same reference signs as those in the first embodiment to omit description.

According to the third embodiment, the termination circuit board 101c is different from the first embodiment in that the termination circuit board 101c further includes the fifth resistor part 8R, the seventh ground conductor line 2G7, and the eighth ground conductor line 2G8.

That is, as illustrated in FIG. 4, the termination circuit board 101c may further include the fifth resistor part 8R positioned with a gap between the fifth resistor part 8R and each of the first signal line 3S1 and the second signal line 3S2. In this case, the ground conductor part 2G includes the seventh ground conductor line 2G7 and the eighth ground conductor line 2G8. The seventh ground conductor line 2G7 is positioned with a gap between the seventh ground conductor line 2G7 and the first region 111 and extends in the x-direction. The eighth ground conductor line 2G8 is positioned between the seventh ground conductor line 2G7 and the first region 111 and extends in the x-direction. The eighth ground conductor line 2G8 is coupled to the first ground conductor line 2G1, the second ground conductor line 2G2, the third ground conductor line 2G3, and the fourth ground conductor line 2G4. The fifth resistor part 8R is coupled to the seventh ground conductor line 2G7 and the eighth ground conductor line 2G8. In other words, the first signal line 3S1 is surrounded by the first ground conductor line 2G1, the second ground conductor line 2G2, and the eighth ground conductor line 2G8. The second signal line 3S2 is surrounded by the third ground conductor line 2G3, the fourth ground conductor line 2G4, and the eighth ground conductor line 2G8.

With such a configuration, as compared with the case without the fifth resistor part 8R, an unnecessary electrical signal generated between the first signal line 3S1 and the second signal line 3S2 is more efficiently convertible to thermal energy. Accordingly, an unnecessary electrical signal can have less possibility of reflecting toward the first signal line 3S1 and the second signal line 3S2.

The fifth resistor part 8R may include a plurality of resistor parts positioned between the seventh ground conductor line 2G7 and the eighth ground conductor line 2G8. More specifically, as illustrated in FIG. 5, the fifth resistor part 8R may include a sixth resistor part 8R6, a seventh resistor part 8R7, and an eighth resistor part 8R8. Further, in an embodiment, the sixth resistor part 8R6 may overlap the third resistor part 6R, the seventh resistor part 8R7 may overlap the second resistor part 5R, and the eighth resistor part 8R8 may overlap the fourth resistor part 7R in side view in the y-direction. With such a configuration, while a resistance value of the fifth resistor part 8R is adjusted, an unnecessary electrical signal can efficiently have less possibility of reflecting toward the first signal line 3S1 and the second signal line 3S2. Note that the positions of the sixth resistor part 8R6, the seventh resistor part 8R7, and the eighth resistor part 8R8 are not limited to those in the embodiment described above.

### (Fourth Embodiment)

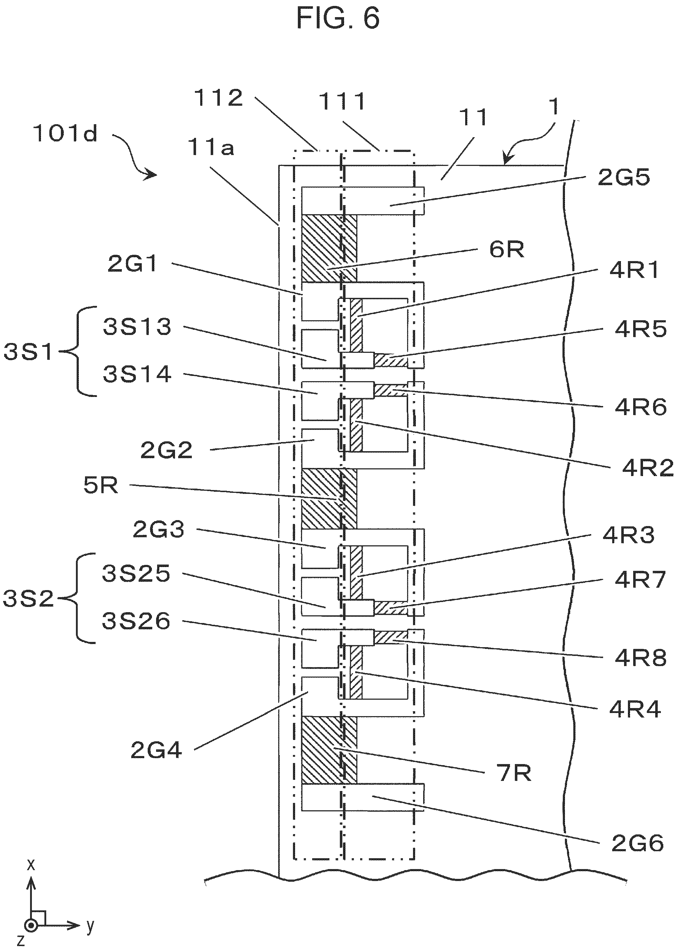

According to a fourth embodiment of the present disclosure, the termination circuit board 101d is described with reference to FIG. 6. Note that, below, only a configuration of the fourth embodiment different from the configuration of the first embodiment is described, and the other configurations are denoted by the same reference signs as those in the first embodiment to omit description.

According to the fourth embodiment, in the termination circuit board 101d, the first signal line 3S1 includes a third signal line 3S13, and a fourth signal line 3S14 positioned with a gap between the fourth signal line 3S14 and the third signal line 3S13. The second signal line 3S2 includes a fifth signal line 3S25, and a sixth signal line 3S26 positioned with a gap between the sixth signal line 3S26 and the fifth signal line 3S25. The first resistor part 4R further includes a fifth resistor 4R5, a sixth resistor 4R6, a seventh resistor 4R7, and an eighth resistor 4R8. In side view in the y-direction, the fifth resistor 4R5 overlaps the third signal line 3S13, the sixth resistor 4R6 overlaps the fourth signal line 3S14, the seventh resistor 4R7 overlaps the fifth signal line 3S25, and the eighth resistor 4R8 overlaps the sixth signal line 3S26.

The first resistor 4R1 and the fifth resistor 4R5 couple the third signal line 3S13 to the first ground conductor line 2G1. The second resistor 4R2 and the sixth resistor 4R6 couple the fourth signal line 3S14 to the second ground conductor line 2G2. The third resistor 4R3 and the seventh resistor 4R7 couple the fifth signal line 3S25 to the third ground conductor line 2G3. The fourth resistor 4R4 and the eighth resistor 4R8 couple the sixth signal line 3S26 to the fourth ground conductor line 2G4. In this case, the third signal line 3S13 and the fourth signal line 3S14 are a pair of signal lines that transmit differential signals. The fifth signal line 3S25 and the sixth signal line 3S26 are a pair of signal lines that transmit differential signals on a channel different from a channel of the first signal line 3S1 (the third signal line 3S13 and the fourth signal line 3S14). With the configuration as described above, unnecessary electrical signals generated between the first signal line 3S1 and the second signal line 3S2 and between the fifth signal line 3S25 and the sixth signal line 3S26 are more efficiently convertible to thermal energy. Accordingly, unnecessary electrical signals can have less possibility of reflecting toward the first signal line 3S1 and the second signal line 3S2.

### <Configuration of Electronic Component Mounting Package>

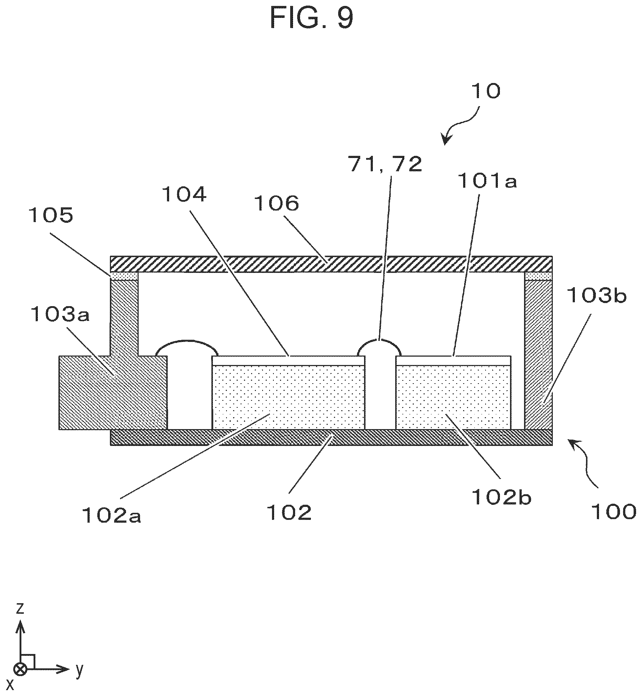

According to an embodiment of the present disclosure, an electronic component mounting package 100 is described with reference to FIG. 9. FIG. 9 is a certain sectional view of an electronic module 10 including the electronic component mounting package 100 with the termination circuit board 101a according to the first embodiment. The electronic component mounting package 100 includes the termination circuit board 101a, a base part 102, and a frame body 103. The frame body 103 is bonded to an upper surface of the base part 102, and the termination circuit board 101a is secured to the frame body 103. The termination circuit board 101a may be bonded to the upper surface of the base part 102.

The base part 102 includes the upper surface. For example, the base part 102 has a quadrilateral shape in plan view, a size of 10 mm × 10 mm to 50 mm × 50 mm, and a thickness of 0.5 mm to 20 mm. Examples of a material for the base part 102 include a metal material, such as copper, iron, tungsten, molybdenum, nickel, or cobalt, or an alloy containing these metal materials. In this case, the base part 102 may be a single metal plate or a multilayer body including a plurality of laminated metal plates. When the material for the base part 102 is the metal material described above, in order to reduce oxidation corrosion, a surface of the base part 102 may be formed with a plating layer of nickel, gold, or the like, by using an electroplating method or an electroless plating method. A material for the base part 102 may be an insulating material, for example, a ceramic material, such as an aluminum oxide-based sintered body, a mullite-based sintered body, a silicon carbide-based sintered body, an aluminum nitride-based sintered body, a silicon nitride-based sintered body, or glass ceramics.

As illustrated in FIG. 9, the base part 102 may include a first pedestal part 102a for mounting the electronic component 104, and a second pedestal part 102b. In this case, the termination circuit board 101a may be mounted on the second pedestal part 102b.

The frame body 103 is positioned on the upper surface of the base part 102 and protects the electronic component 104 positioned inside in plan view. That is, the frame body 103 surrounds the electronic component 104 when seen in plan view. As illustrated in FIG. 9, in an embodiment, the frame body 103 may include a wiring base part 103a to communicate a signal to/from an external device, and a frame part 103b. That is, the wiring base part 103a and the frame part 103b surround an outer edge of the upper surface of the base part 102. In other words, the wiring base part 103a and the frame part 103b surround the electronic component 104. Although in an embodiment the frame body 103 is positioned along the outer edge of the upper surface of the base part 102, the frame body 103 may be positioned at an inner side of the outer edge of the upper surface of the base part 102.

A material for the frame body 103 may be, for example, a metal material, such as copper, iron, tungsten, molybdenum, nickel, or cobalt, or an alloy containing these metal materials. The material for the frame body 103 may be an insulating material, for example, a ceramic material, such as an aluminum oxide-based sintered body, a mullite-based sintered body, a silicon carbide-based sintered body, an aluminum nitride-based sintered body, a silicon nitride-based sintered body, or glass ceramics. When the frame body 103 includes the wiring base part 103a, as a material for the wiring base part 103a, for example, a dielectric material, such as a ceramic material, for example, an aluminum oxide-based sintered body, a mullite-based sintered body, a silicon carbide-based sintered body, an aluminum nitride-based sintered body, or a silicon nitride-based sintered body, or a glass-ceramic material can be used. The wiring base part 103a may include a configuration in which multiple insulating layers are laminated on one another. The materials for the wiring base part 103a and the frame part 103b may be the same as or different from one another.

When the frame body 103 includes the wiring base part 103a, a green sheet to have an external shape of the wiring base part 103a may be formed with wiring by using a metal material, such as gold, silver, copper, nickel, tungsten, molybdenum, or manganese. The wiring may be formed by sintering of metal paste, or formed by using a thin-film formation technology, such as a vapor deposition method or a spattering method. An insulating film, such as a ceramic (for example, aluminum coat) or a resin may be positioned on a portion of the wiring.

The frame body 103 may be bonded to the base part 102 with a brazing material or the like interposed therebetween. Note that a material for the brazing material is, for example, silver, copper, gold, aluminum, or magnesium, and may contain an additive such as nickel, cadmium, or phosphorus.

### <Configuration of Electronic Module>

According to an embodiment of the present disclosure, the electronic module 10 is described. As illustrated in FIG. 9, the electronic module 10 includes the electronic component mounting package 100, the electronic component 104, and a lid body 106. The electronic module 10 may include a seal ring 105.

The electronic component 104 may be, for example, a component which performs signal processing, such as conversion of an optical signal into an electrical signal, or conversion of an electrical signal into an optical signal. The electronic component 104 is positioned on the upper surface of the base part 102 and is accommodated in the electronic component mounting package 100.

Examples of the electronic component 104 include an optical semiconductor element, such as a semiconductor laser (LD: laser diode) or a photo diode (PD), a semiconductor integrated circuit element, and a sensor element such as an optical sensor. For example, the electronic component 104 can be made of a semiconductor material, such as gallium arsenide or gallium nitride.

The electronic component 104 may include a thin-film resistor. The thin-film resistor may be provided in a configuration the same as and/or similar to the configuration of the termination circuit board 101a. Therefore, also from the perspective of the electronic component, an unnecessary electrical signal generated between the first signal line 3S1 and the second signal line 3S2 and/or between the seventh signal line 104S7 and the eighth signal line 104S8 is convertible to thermal energy. Accordingly, an unnecessary electrical signal can have less possibility of reflecting toward the first signal line 3S1 and the second signal line 3S2, and/or the seventh signal line 104S7 and the eighth signal line 104S8.

The electronic component 104 may directly be mounted on the base part 102, or may be mounted with the first pedestal part 102a interposed therebetween as described above.

The lid body 106 is positioned on the frame body 103 to cover an internal portion of the electronic component mounting package 100, and protects, together with the frame body 103, the electronic component 104. For example, the lid body 106 has a quadrilateral shape in plan view, a size of 10 mm × 10 mm to 50 mm × 50 mm, and a thickness of 0.5 mm to 2 mm. Examples of a material for the lid body 106 include a metal material, such as iron, copper, nickel, chromium, cobalt, molybdenum, or tungsten, or an alloy combining multiple materials among these metal materials. By application of metalworking such as rolling processing or punching processing to an ingot of such a metal material, the metal member which configures the lid body 106 can be fabricated.

The seal ring 105 functions to bond the lid body 106 and the frame body 103. The seal ring 105 is positioned on the frame body 103 to surround the electronic component 104 in plan view. Examples of a material for the seal ring 105 include a metal material, such as iron, copper, silver, nickel, chromium, cobalt, molybdenum, or tungsten, or an alloy combining multiple materials among these metal materials. Note that in a case of not providing the seal ring 105 on the frame body 103, the lid body 106 may be bonded through a bonding material, such as solder, a brazing material, glass, or a resin adhesive material.

Note that various combinations of feature parts in an embodiment are not limited to the examples in the embodiments described above. The embodiments can be combined together.

### INDUSTRIAL APPLICABILITY

The present disclosure is applicable to a termination circuit board, an electronic component mounting package, and an electronic module.

### REFERENCE SIGNS

1 dielectric substrate
11 first surface
11a first side
111 first region
112 second region
2G ground conductor part
2G1 first ground conductor line
2G1a first end part
2G2 second ground conductor line
2G2a second end part
2G3 third ground conductor line
2G3a second end part
2G4 fourth ground conductor line
2G4a second end part
2G5 fifth ground conductor line
2G6 sixth ground conductor line
2G7 seventh ground conductor line
2G8 eighth ground conductor line
3S signal conductor part
3S1 first signal line
3S1a fifth end part
3S1b first wide part
3S1c first narrow part
3S13 third signal line
3S14 fourth signal line
3S2 second signal line
3S2a sixth end part
3S25 fifth signal line
3S26 sixth signal line
4R first resistor part
4R1 first resistor
4R2 second resistor
4R3 third resistor
4R4 fourth resistor
4R5 fifth resistor
4R6 sixth resistor
4R7 seventh resistor
4R8 eighth resistor
5R second resistor part
5R1a seventh end part
6R third resistor part
7R fourth resistor part
8R fifth resistor part
8R6 sixth resistor part
8R7 seventh resistor part
8R8 eighth resistor part
71 first wire
72 second wire
73 third wire
74 fourth wire
75 fifth wire
76 sixth wire
L1 first distance
L2 second distance
L3 third distance
L712a-b distance between first wire and second wire
L734a-b distance between third wire and fourth wire
L4 fourth distance
L5 fifth distance
L6 sixth distance
D1 first dimension
D2 second dimension
C1 virtual line
10 electronic module
100 electronic component mounting package
101a-d termination circuit board
102 base part
102a first pedestal part
102b second pedestal part
103 frame body
103a wiring board
103b frame part
104 electronic component
104S7 seventh signal line
104S8 eighth signal line
104G tenth ground conductor line
105 seal ring
106 lid body

## Claims

1. A termination circuit board comprising:
a dielectric substrate comprising a first surface with a first side; and
when a direction along the first side is a first direction and a direction intersecting with the first direction is a second direction,
a ground conductor part positioned on the first surface in such a manner that a distance in the second direction between the ground conductor part and the first side is a first distance;
a signal conductor part positioned on the first surface in such a manner that a distance in the second direction between the signal conductor part and the first side is a second distance;
a first resistor part positioned on the first surface and configured to couple the ground conductor part to the signal conductor part; and
a second resistor part positioned on the first surface in such a manner that a distance in the second direction between the second resistor part and the first side is a third distance, wherein
the ground conductor part comprises a first ground conductor line, a second ground conductor line, a third ground conductor line, and a fourth ground conductor line aligned in order in the first direction,
the signal conductor part comprises a first signal line positioned between the first ground conductor line and the second ground conductor line in the first direction, and a second signal line positioned between the third ground conductor line and the fourth ground conductor line in the first direction,
the first resistor part comprises a first resistor configured to couple the first ground conductor line to the first signal line in the first direction, a second resistor configured to couple the second ground conductor line to the first signal line in the first direction, a third resistor configured to couple the third ground conductor line to the second signal line in the first direction, and a fourth resistor configured to couple the fourth ground conductor line to the second signal line in the first direction, and
the second resistor part couples the second ground conductor line to the third ground conductor line in the first direction.

2. A termination circuit board comprising:
a dielectric substrate comprising a first surface with a first side; and
when a direction along the first side is a first direction and a direction intersecting with the first direction is a second direction,
a ground conductor part positioned on the first surface in such a manner that a distance in the second direction between the ground conductor part and the first side is a first distance;
a signal conductor part positioned on the first surface in such a manner that a distance in the second direction between the signal conductor part and the first side is a second distance; and
a first resistor part positioned on the first surface and configured to couple the ground conductor part to the signal conductor part, wherein
the ground conductor part comprises a first ground conductor line, a second ground conductor line, a third ground conductor line, and a fourth ground conductor line aligned in order in the first direction,
the signal conductor part comprises a first signal line positioned between the first ground conductor line and the second ground conductor line in the first direction, and a second signal line positioned between the third ground conductor line and the fourth ground conductor line in the first direction,
the first resistor part comprises a first resistor configured to couple the first ground conductor line to the first signal line in the first direction, a second resistor configured to couple the second ground conductor line to the first signal line in the first direction, a third resistor configured to couple the third ground conductor line to the second signal line in the first direction, and a fourth resistor configured to couple the fourth ground conductor line to the second signal line in the first direction, and
the second ground conductor line and the third ground conductor line are positioned apart from one another in the first direction.

3. The termination circuit board according to claim 1 or 2, wherein the first surface comprises:
a first region positioned with a gap between the first region and the first side and extending in the first direction; and
a second region positioned between the first side and the first region and extending in the first direction,
the first signal line, the second signal line, the first ground conductor line, the second ground conductor line, the third ground conductor line, and the fourth ground conductor line extend from the second region to the first region in the second direction intersecting with the first direction,
the first resistor, the second resistor, the third resistor, and the fourth resistor are positioned only in the first region, and
in the first direction, a distance in the second region between the first signal line and each of the first ground conductor line and the second ground conductor line is shorter than a distance in the first region between the first signal line and each of the first ground conductor line and the second ground conductor line.

4. The termination circuit board according to any one of claims 1 to 3, wherein in the second direction intersecting with the first direction, a dimension of each of the first signal line and the second signal line is equal to or more than a dimension of each of the first ground conductor line, the second ground conductor line, the third ground conductor line, and the fourth ground conductor line.

5. The termination circuit board according to claim 1, wherein the first surface comprises:
a first region positioned with a gap between the first region and the first side and extending in the first direction; and
a second region positioned between the first side and the first region and extending in the first direction,
in the second region,
the first ground conductor line comprises a first end part,
the second ground conductor line comprises a second end part,
the third ground conductor line comprises a third end part,
the fourth ground conductor line comprises a fourth end part,
the first signal line comprises a fifth end part,
the second signal line comprises a sixth end part, and
the second resistor part comprises a seventh end part, and
the first end part, the second end part, the third end part, the fourth end part, the fifth end part, the sixth end part, and the seventh end part are positioned in a straight line in the first direction.

6. The termination circuit board according to any one of claims 1 to 4, wherein the first surface comprises:
a first region positioned with a gap between the first region and the first side and extending in the first direction; and
a second region positioned between the first side and the first region and extending in the first direction,
in the second region,
the first ground conductor line comprises a first end part,
the second ground conductor line comprises a second end part,
the third ground conductor line comprises a third end part,
the fourth ground conductor line comprises a fourth end part,
the first signal line comprises a fifth end part, and
the second signal line comprises a sixth end part, and
the first end part, the second end part, the third end part, the fourth end part, the fifth end part, and the sixth end part are positioned in a straight line in the first direction.

7. The termination circuit board according to any one of claims 1 to 6, further comprising a third resistor part and a fourth resistor part positioned on the first surface, wherein
the ground conductor part comprises a fifth ground conductor line and a sixth ground conductor line,
the third resistor part couples the first ground conductor line to the fifth ground conductor line, and
the fourth resistor part couples the fourth ground conductor line to the sixth ground conductor line.

8. The termination circuit board according to any one of claims 1 to 7, further comprising a fifth resistor part positioned with a gap between the fifth resistor part and each of the first signal line and the second signal line, wherein
the first surface comprises:
a first region positioned with a gap between the first region and the first side and extending in the first direction; and
a second region positioned between the first side and the first region and extending in the first direction,
the ground conductor part comprises a seventh ground conductor line positioned with a gap between the seventh ground conductor line and the first region and extending in the first direction, and
the fifth resistor part is coupled to the first ground conductor line, the second ground conductor line, the third ground conductor line, and the fourth ground conductor line, as well as to the seventh ground conductor line.

9. The termination circuit board according to any one of claims 1 to 8, further comprising a fifth resistor part positioned with a gap between the fifth resistor part and each of the first signal line and the second signal line, wherein
the first surface comprises:
a first region positioned with a gap between the first region and the first side and extending in the first direction; and
a second region positioned between the first side and the first region and extending in the first direction,
the ground conductor part comprises:
a seventh ground conductor line positioned with a gap between the seventh ground conductor line and the first region and extending in the first direction; and
an eighth ground conductor line positioned between the seventh ground conductor line and the first region and extending in the first direction,
the eighth ground conductor line is coupled to the first ground conductor line, the second ground conductor line, the third ground conductor line, and the fourth ground conductor line, and
the fifth resistor part is coupled to the seventh ground conductor line and the eighth ground conductor line.

10. The termination circuit board according to any one of claims 1 to 9, further comprising a first wire and a second wire configured to electrically couple the first signal line to an electronic component, and a third wire and a fourth wire configured to electrically couple the second signal line to the electronic component, and
in plan view,
a distance in the second direction between the first wire and the second wire decreases outwardly in the second direction, and
a distance in the second direction between the third wire and the fourth wire decreases outwardly in the second direction.

11. The termination circuit board according to claim 1 or 5, wherein each of the first resistor part and the second resistor part is a thin-film resistor.

12. The termination circuit board according to any one of claims 1, 5, and 11, wherein a material for the first resistor part and the second resistor part comprises TaN or Ta2N as a main component.

13. The termination circuit board according to any one of claims 1 to 12, wherein the first signal line comprises a third signal line, and a fourth signal line positioned with a gap between the fourth signal line and the third signal line,
the second signal line comprises a fifth signal line, and a sixth signal line positioned with a gap between the sixth signal line and the fifth signal line,
in side view in the second direction, the first resistor part comprises:
a fifth resistor overlapping the third signal line;
a sixth resistor overlapping the fourth signal line;
a seventh resistor overlapping the fifth signal line; and
an eighth resistor overlapping the sixth signal line,
the first resistor and the fifth resistor couple the third signal line to the first ground conductor line,
the second resistor and the sixth resistor couple the fourth signal line to the second ground conductor line,
the third resistor and the seventh resistor couple the fifth signal line to the third ground conductor line, and
the fourth resistor and the eighth resistor couple the sixth signal line to the fourth ground conductor line.

14. An electronic component mounting package comprising:
a base part;
a frame body bonded to an upper surface of the base part; and
the termination circuit board according to any one of claims 1 to 13, the termination circuit board being mounted on the upper surface.

15. An electronic module comprising:
the electronic component mounting package according to claim 14;
an electronic component positioned on the upper surface of the base part and electrically coupled to the termination circuit board of the electronic component mounting package; and
a lid body positioned on the frame body to cover an internal portion of the electronic component mounting package.
